(19) Europäisches Patentamt

European Patent Office

Office européen des brevets

(11) Veröffentlichungsnummer: **0 393 600 B1**

(12) **EUROPÄISCHE PATENTSCHRIFT**

(45) Veröffentlichungstag der Patentschrift: **29.11.95**

(21) Anmeldenummer: **90107284.3**

(22) Anmeldetag: **17.04.90**

(51) Int. Cl.⁶: **C30B 23/06**

(54) **Vorrichtung mit einem Tiegel in einer Effusionszelle einer Molekularstrahlepitaxieanlage.**

(30) Priorität: **19.04.89 DE 8904944 U**
**17.05.89 DE 3916017**

(43) Veröffentlichungstag der Anmeldung:
**24.10.90 Patentblatt 90/43**

(45) Bekanntmachung des Hinweises auf die
Patenterteilung:
**29.11.95 Patentblatt 95/48**

(84) Benannte Vertragsstaaten:
**DE FR GB**

(56) Entgegenhaltungen:
**FR-A- 2 490 250**
**US-A- 4 646 680**

**PATENT ABSTRACTS OF JAPAN, Band 13,
Nr. 107 (C-576)[3455], 14. März 1989; & JP-
A-63 282 190 (AGENCY OF IND. SCIENCE &
TECHNOLOGY)18-11-1988**

(73) Patentinhaber: **SIEMENS AKTIENGESELL-
SCHAFT**
**Wittelsbacherplatz 2**
**D-80333 München (DE)**

(72) Erfinder: **Reithmaier, Johann-Peter,
Dipl.-Phys.**
**Klosterstrasse 3**
**D-8311 Niederviehbach (DE)**
Erfinder: **Schlötterer, Heinrich, Dr.-Dipl.-Phys.**
**Andreas Wagner Strasse 11A**
**D-8011 Putzbrunn Solalinden (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Molekularstrahlepitaxie (MBE) ist ein Verfahren zum kontrollierten Wachstum von einkristallinen Halbleiterschichten im Schichtdickenbereich von 0,1 nm bis 10 μm. Bei einer Feststoffquellen-MBE werden dazu Materialien im Ultrahochvakuum in speziellen Tiegeln thermisch verdampft. Das dabei freigesetzte Material bildet im verwendeten Druckbereich von weniger als $10^{-6}$ mbar einen Molekularstrahl. Die Verdampferquellen besitzen deshalb eine gewisse Richtungscharakteristik, die von der Tiegelform abhängt. Für die Verwendung einer Molekularstrahlepitaxie in der Halbleiterfertigung ist hohe Schichtdickenhomogenität eine Voraussetzung für hohe Ausbeute bei Heteroschichtstruktur-Bauelementen.

Die Dickenhomogenität einer Halbleiterschicht wird bei einer Feststoffquellen-Molekularstrahlepitaxie im wesentlichen durch folgende Punkte bestimmt:

1. Formgebung des Quellentiegels,
2. geometrische Anordnung des Tiegels bezüglich des Halbleitersubstrats,
3. Rotation des Substrates.

Für die Herstellung von neueren Halbleiterstrukturen werden unterschiedliche Materialien in verschiedenen Zellen verwendet. Dazu ist es nötig die Zellen rotationssymmetrisch um die Flächennormale des Substrats anzuordnen. Die dabei entstehende Asymmetrie in der Verteilung des Materialflusses über die Substratscheibe wird durch Rotieren der Scheibe teilweise wieder ausgeglichen.

Bis jetzt wurden im wesentlichen zwei Konzepte verfolgt, um die Schichtdickenhomogenität zu optimieren. Die erste Möglichkeit besteht darin, zylinderförmige, schwach konische Tiegel mit kleinen Öffnungen zu verwenden, die Vorteile in der Temperaturregulierung bringen und nur geringe Materialverluste wegen der starken Strahlkollimierung haben. Den Nachteil der Strahlkollimierung für die Schichtdickenhomogenität versucht man dadurch auszugleichen, daß man das Maximum der Flußverteilung durch Verkippung der Zellenachse vom Substratmittelpunkt zum Substratrand verschiebt. Mit der Subtratrotation als Mittelungsverfahren erreicht man dadurch eine geringere Schichtdickenvariation über einen größeren Substratbereich als ohne Verkippung.

Die zweite Möglichkeit besteht darin, stärker konische Tiegel mit kreisförmigem Querschnitt zu verwenden, bei denen die Quellenfläche direkten Sichtkontakt zur gesamten Substratfläche besitzt. Mit Querschnitt des Tiegels ist hierbei wie im folgenden ein Schnitt senkrecht zur Mittelachse des Tiegels, d.h. senkrecht zur Molekularstrahlrichtung gemeint. Die Symmetrieachse zielt dabei nahezu zum Mittelpunkt der Substratscheibe (J.A. Curless, J.Vac.Sci.Technol. B3 (2), 531 - 534 (1985)). Die Rotation gleicht hier nurmehr den Effekt des schrägen Einfalls des Molekularstrahls auf die Substratscheibe aus, so daß im Prinzip deutlich bessere Homogenität als bei dem ersten Verfahren erreicht wird.

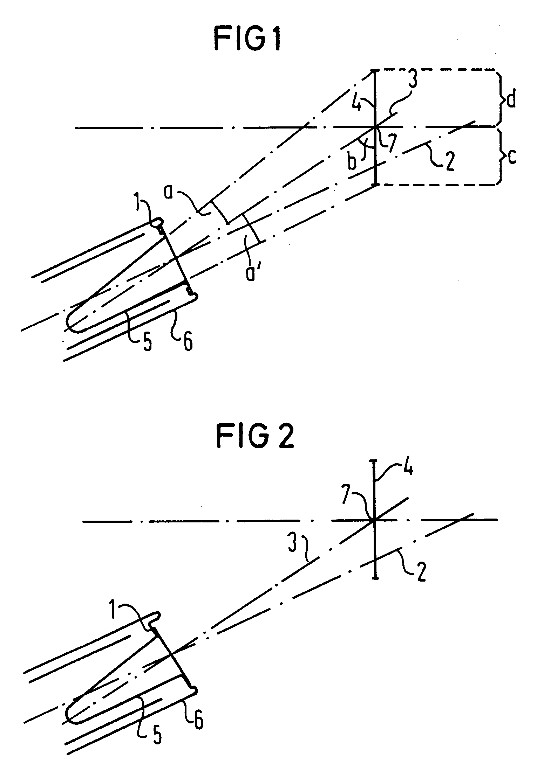

In der französischen Patentanmeldung 2490250 ist eine Molekularstrahlepitaxieanlage beschrieben, bei der konische Tiegel wie in Fig.2 dieser französischen Anmeldung verwendet werden. Der Molekularstrahl wird schräg auf das Substrat gerichtet. Der Öffnungswinkel des Tiegels wird so groß gewählt, daß das gesamte Substrat von dem Molekularstrahl überstrichen wird. In der japanischen Anmeldung JP 6191094 ist ebenfalls ein konischer Tiegel mit einem Öffnungswinkel, der für eine hinreichend große Aufweitung des Molekularstrahls sorgt, beschrieben.

In der japanischen Anmeldung JP 63282190 ist ein konischer Tiegel beschrieben, der zwar in einem Schnitt vertikal der Längsachse kreisförmig ist, dessen Öffnung aber schräg ausgeschnitten und daher elliptisch ist. Diese Formgebung betrifft den Einbau des Tiegels in die Molekularstrahlanlage und nicht die Querschnittsform des austretenden Molekularstrahles.

In der japanischen Anmeldung JP 63252996 ist ein abgeflachter Tiegel mit schräg angeschnittener und daher länglicher, ellipsenähnlicher Öffnung beschrieben, womit eine großflächige, gleichförmige Beschichtung möglich sein soll.

Diese zweite Methode erzielt über größere Substratbereiche höhere Dickenhomogenität als die vorgenannte Methode. Um jedoch auch in Anlagen, die nach dem ersten Konzept optimiert wurden, eine Strahlflußverteilung wie im zweiten Verfahren zu erreichen, kann im Prinzip der Öffnungswinkel des konischen Tiegels so groß gemacht werden, daß das gesamte Substrat sich im Bereich des Molekularstahles befindet. Dies hat aber folgende Nachteile:

1. Bei gegebener Tiegelöffnung nimmt das nutzbare Tiegelvolumen deutlich ab.
2. Die Wachstumsraten sind sehr stark vom Füllgrad abhängig.
3. Ein großer Prozentsatz des Materials geht an der Substratscheibe vorbei.
4. Auch ein großer Teil der Hitzestrahlung geht vorbei und heizt die Wachstumskammer an unerwünschten Stellen auf.
5. Der in der Ebene des Substrates geführte Schnitt durch den Molekularstrahl ist nahezu elliptisch, so daß bei den üblichen kreisrunden Subtraten und Substratträgern der Materialfluß nicht voll ausgenutzt wird.

Aufgabe der vorliegenden Erfindung ist es, eine Vorrichtung mit einem Tiegel in einer Effusionszelle einer Molekularstrahlepitaxieanlage anzugeben, bei der die Effusionszelle relativ zum Substrat gekippt ist und bei der der Molekularstrahl im Hinblick auf Materialverbrauch optimiert ist.

Diese Aufgabe wird mit einem Tiegel mit den Merkmalen des Anspruches 1, mit einer Anordnung mit den Merkmalen des Anspruches 3 und mit einer Vorrichtung mit den Merkmalen des Anspruches 11 oder 18 gelöst. Weitere Ausgestaltungen ergeben sich aus den Unteransprüchen.

Figur 1 und 2 zeigen zwei erfindungsgemäße Vorrichtungen im Querschnitt.

Die erfindungsgemäße Vorrichtung findet insbesondere dann Anwendung, wenn mehrere Effusionszellen vor einem zu beschichtenden kreisförmigen Substrat 4 angeordnet sind und die einzelnen Molekularstrahlen schräg auf das Substrat 4 auftreffen. Die erfindungsgemäße Vorrichtung bietet in diesen Fällen den Vorteil, daß der Molekularstrahl optimal auf das Substrat gerichtet wird, so daß der gesamte Molekularstrahl das Substrat 4 trifft und gleichzeitig eine möglichst homogene Beschichtung des Substrates sichergestellt ist. Die erfindungsgemäße Vorrichtung erreicht das dadurch, daß die Formgebung des Tiegels so gestaltet wird, daß der Molekularstrahl einen Querschnitt aufweist, der der Projektion des Substrates in der Strahlrichtung entspricht.

Bei der erfindungsgemäßen Vorrichtung ist der Tiegel 5, wie in Fig. 1 dargestellt, relativ zu der Zelle 6 gekippt. Auf diese Weise wird erreicht, daß die Mittelachse des Tiegels 5 auf den Mittelpunkt 7 des zu beschichtenden Objekts 4 (Substrat) ausgerichtet ist, während gleichzeitig die Mittelachse 2 der Zelle 6 außerhalb dieses Mittelpunktes 7 des zu beschichtenden Objektes 4 verläuft. Der Öffnungswinkel des Tiegels wird dabei so klein bemessen, daß der Molekularstrahl nur das zu beschichtende Objekt 4 überstreicht. Der besondere Vorteil dieser Anordnung ist darin zu sehen, daß weder an einer bestehenden Zellenanordnung mit exzentrisch zum Substratmittelpunkt ausgerichteter Mittelachse noch am eigentlichen Zellendesign etwas geändert werden muß. Daher kann diese erfindungsgemäße Vorrichtung einfach in bereits bestehenden Anlagen installiert werden.

Maßgebliche Merkmale für die Formgebung des Tiegels 5 sind dabei

1. die Größe und die Form der Öffnung des Tiegels,
2. der Öffnungswinkel (a + a′),
3. die Form des Tiegelquerschnittes und
4. die Form und Anordnung des Kragens des Tiegels.

Unter der Öffnung des Tiegels 5 ist dabei die lineare Projektion der Seitenwände des Tiegels in die Ebene, die durch den vorderen Rand der Effusionszelle 6 gebildet wird, zu verstehen. Um die Ausrichtung des Molekularstrahles zu bewirken, sind die Querschnitte des Tiegels gemäß oben angegebener Definition praktisch über die gesamte Tiegellänge einander ähnlich, d.h. nur im Maßstab verschieden. Der Kragen des Tiegels 5 ist an dessen Öffnung angebracht und dient zur Befestigung des Tiegels 5 an der Tiegelhalterung 1 der Zelle 6.

Die Öffnung des Tiegels 5 und dessen Seitenwände, die die Begrenzung des Molekularstrahles festlegen, sind so ausgebildet, daß die seitliche Begrenzung des Molekularstrahles gerade mit der Begrenzung des Substrates 4 zusammentrifft. Die Mittenachse 3 des Tiegels 5 trifft das Substrat 4 etwa in dessen Mittelpunkt 7. Im Spezialfall eines Tiegels 5 mit kreisförmigem Querschnitt, bei dem die Mittenachse 3 in dem in Fig. 1 gezeigten Querschnitt die Winkelhalbierende des Molekularstrahles (a = a′) bildet, ergibt sich mit den in Fig. 1 eingezeichneten Bezugszeichen die Beziehung $c \sin (a + b) = d \sin (b - a)$. Die Mittelachse 3 des Tiegels 5 trifft dann das Substrat 4 um $(d - c)/2$ von dem tatsächlichen Mittelpunkt 7 nach unten versetzt.

In den Figuren ist eine Vorrichtung mit einem Tiegel in einer Effusionszelle dargestellt, bei der der Tiegel in der Zelle so verkippt ist, daß die Mittelachse des Tiegels zu der Mittelachse der Zelle einen Winkel bildet. Sei der erfindungsgemäßen Vorrichtung kann zur Optimierung des Molekularstrahles bei einer Zelle 6, deren Mittelachse außerhalb des Mittelpunktes 7 des Substrates 4 verläuft, eine derartige Verkippung des Tiegels 5 in der Zelle 6 erforderlich sein. Um diese eventuell erforderliche Verkippung des Tiegels 5 in der Zelle 6, d.h. einen Winkel größer als Null zwischen der Mittelachse 3 des Tiegels 5 und der Mittelachse 2 der Zelle 6 zu bewirken, muß der obere Rand des Tiegels 5, der mit einem Kragen zur Befestigung des Tiegels 5 an der Tiegelhalterung 1 versehen ist, so ausgebildet sein, daß diese Verkippung bewirkt ist. Die Ebene, in der der Kragen liegt, ist hierbei also nicht senkrecht zur Mittelachse 3 des Tiegels 5. Die Tiegelöffnung selbst ist elliptisch.

Im Falle einer modifizierten, d.h. nicht rotationssymmetrisch bezüglich der Zelle 6 ausgebildeten Tiegelhalterung 1 kann die Öffnung des Tiegels 5 selbst wieder kreisförmig sein (Fig. 2).

Bei einem Tiegel 5 mit kreisförmigem Querschnitt ist der Querschnitt des Molekularstrahles kreisförmig. Eine weitere Optimierung des Molekularstrahles auf das Substrat 4 ist mit diesem kreisförmigen Querschnitt des Tiegels 5 nicht möglich. Zur weiteren Optimierung sieht die erfindungsgemäße Vorrichtung vor, auch die Form des Tiegels 5 dahingehend zu ändern, daß sich für den Querschnitt des Tiegels 5 und damit des Molekularstrahles näherungsweise eine Ellipse ergibt. Im Falle eines genau parallel ausgerichteten Molekularstrahles (a = 0) wäre dieser Querschnitt genau eine Ellipse. Um diese weitere Optimierung des Molekularstrahles zu erreichen, wird der Tiegel 5 erfindungsgemäß in einer abgeflachten, d.h. im Querschnitt elliptischen Form ausgebildet. Die Öffnung des Tiegels 5 und der Öffnungswinkel (a + a') werden dahingehend an die Erfordernisse der Optimierung angepaßt, daß der Molekularstrahl am Ort des Substrates 4 genau auf dessen Abmessungen aufgeweitet ist.

In dem speziellen Fall, daß die Zelle 6 so angeordnet ist, daß ihre Mittelachse 2 außerhalb des Mittelpunktes 7 des Substrates 4 verläuft, liefert die Notwendigkeit, den Tiegel 5 gegenüber der Zelle 6 zu verkippen, zusätzliche Randbedingungen, was die Formgebung des Tiegels 5 betrifft. Der Raum, der von dem Tiegel 5 eingenommen werden kann, wird durch die Innenwandung oder andere Innenteile der Zelle 6 eingeschränkt. Bei gegebenem Abstand der Zelle 6 von dem Substrat 4, der im Zuge der Optimierung erforderlichen Öffnungswinkel des Molekularstrahles und dem entsprechend der Anordnung der Zelle 6 erforderlichen Verkippungswinkels des Tiegels 5 in der Zelle 6 muß gegebenenfalls die Tiegelöffnung so verkleinert werden, daß eine ausreichende Verkippung des Tiegels 5 in der Zelle 6 möglich ist. Der Kragen des Tiegels 5 wird dann zweckmäßigerweise so breit ausgebildet, daß der nicht von dem Tiegel eingenommene Anteil des Innenraumes der Zelle 6 durch diesen Kragen des Tiegels 5 nach außen abgeschlossen wird. Entsprechend kann zusätzlich die Tiegelhalterung 1 der Zelle 6 modifiziert werden.

Die Vorteile der erfindungsgemäßen Vorrichtung sind darin zu sehen, daß die Öffnungsfläche des Tiegels vollen Sichtkontakt zur Substratfläche besitzt, daß gleichzeitig ein gegenüber dem Stand der Technik kleinerer Öffnungswinkel erforderlich ist, daß weiterhin das Tiegelvolumen wesentlich größer bemessen werden kann und die Materialverluste stark reduziert sind. Ebenfalls hat aufgrund des geringeren Öffnungswinkel die Abhängigkeit von dem Füllstand, d. h. der Höhe des in dem Tiegel eingefüllten Materials, abgenommen. Die Tiegelform selbst kann nach wie vor kreissymmetrisch sein. Der Tiegel ist dann z. B. mit einem um den Winkel zwischen den Mittelachsen 2, 3 geneigten Kragen versehen, um an die bezüglich der Mittelachse 2 der Zelle 6 rotationssymmetrisch angeordneten Tiegelhalterung 1 angepaßt zu sein.

**Patentansprüche**

1. Tiegel zur Erzeugung eines Molekularstrahls für eine Molekularstrahlepitaxieanlage
   mit einer Öffnung,
   mit einem Öffnungswinkel,
   mit einem durch diesen Öffnungswinkel begrenzten Querschnitt und
mit einer die Richtung des Molekularstrahls definierenden Mittelachse,
**dadurch gekennzeichnet,**
daß der Tiegel (5) in einer zur Mittelachse (3) senkrechten Ebene einen durch diesen Öffnungswinkel begrenzten Querschnitt aufweist, der von der Kreisform abweicht.

2. Tiegel nach Anspruch 1,
   **dadurch gekennzeichnet,**
   daß der Querschnitt des Tiegels (5) im wesentlichen elliptisch ist.

3. Anordnung eines Tiegels nach Anspruch 1 oder 2
   relativ zu einem vorgesehenen Mittelpunkt (7) auf einer Oberfläche eines zu beschichtenden Objekts (4),
   **dadurch gekennzeichnet,**
   daß die Mittelachse (3) des Tiegels (5) auf diesen Mittelpunkt (7) gerichtet ist.

4. Anordnung eines Tiegels nach einem der Ansprüche 1 bis 3, relativ zu einem vorgesehenen Mittelpunkt (7) auf einer Oberfläche eines zu beschichtenden Objekts (4),
   **dadurch gekennzeichnet,**
   daß die Mittelachse (3) schräg zu dieser Oberfläche des zu beschichtenden Objekts (4) verläuft.

5. Anordnung eines Tiegels zur Erzeugung eines Molekularstrahls, insbesondere eines Tiegels nach einem der Ansprüche 1 bis 4, in einer Zelle (6) einer Molekularstrahlepitaxieanlage,
   bei der dieser Tiegel (5) eine die Richtung des Molekularstrahles bestimmende Mittelachse (3) und diese Zelle (6) eine Mittelachse (2) aufweisen,
   **dadurch gekennzeichnet,**
   daß der Tiegel (5) derart angeordnet ist, daß diese Mittelachsen (2, 3) schräg zueinander verlaufen.

6. Anordnung nach Anspruch 5,
   **dadurch gekennzeichnet,**
   daß die Mittelachse (3) des Tiegels (5) auf einen vorgesehenen Mittelpunkt (7) auf einer Oberfläche eines zu beschichtenden Objekts (4) gerichtet ist.

7. Anordnung nach Anspruch 5 oder 6,
   **dadurch gekennzeichnet,**
   daß die Mittelachse (3) des Tiegels (5) schräg zur Oberfläche des zu beschichtenden Objekts (4) verläuft.

8. Anordnung nach einem der Ansprüche 5 bis 7, **dadurch gekennzeichnet,** daß die Zelle (6) eine Tiegelhalterung (1) mit einer den Winkel zwischen der Mittelachse (2) der Zelle (6) und der Mittelachse (3) des Tiegels (5) bewirkenden Formgebung hat.

9. Anordnung nach einem der Ansprüche 5 bis 8, **dadurch gekennzeichnet,** daß ein zur Befestigung des Tiegels (5) in der Zelle (6) am Tiegel (5) vorgesehener Kragen so gestaltet ist, daß damit eine vorgesehene Ausrichtung der Mittelachse (3) des Tiegels (5) bewirkt ist.

10. Anordnung nach einem der Ansprüche 5 bis 9, **dadurch gekennzeichnet,** daß ein zur Befestigung des Tiegels (5) in der Zelle (6) am Tiegel (5) vorgesehener Kragen so gestaltet ist, daß der zwischen der Außenwand des Tiegels (5) und der Innenwand der Zelle (6) befindliche Innenraum der Zelle (6) nach außen abgeschlossen ist.

11. Vorrichtung für Gebrauch in einer Molekularstrahlepitaxieanlage zum Beschichten eines Substrates, wobei dieses Substrat an einem vorbestimmten Ort derart angebracht werden kann, daß es eine vorbestimmte Substratfläche (4) einnimmt, wobei diese Vorrichtung umfaßt
eine Effusionszelle (6),
einen Tiegel (5) in dieser Effusionszelle (6), wobei dieser Tiegel (5) exzentrisch relativ zu diesem vorbestimmten Ort angeordnet ist,
wobei dieser Tiegel (5) einen Öffnungswinkel (a + a'),
eine von der Kreisform abweichende Form des zu einer Mittelachse (3) des Tiegels (5) senkrecht verlaufenden, durch diesen Öffnungswinkel begrenzten Querschnitts und
eine Ausrichtung dieser Mittelachse (3) aufweist, die zusammen einen Querschnitt und eine Richtung eines aus diesem Tiegel (5) austretenden Molekularstrahles definieren, so daß dieser Molekularstrahl diesen vorbestimmten Ort überstreicht und diese vorbestimmte Substratfläche (4) zumindest weitgehend genau trifft.

12. Vorrichtung nach Anspruch 11, bei der die vorbestimmte Substratfläche (4) als kreisförmig vorgesehen ist und bei der die Form des zu der Mittelachse (3) senkrecht verlaufenden Querschnitts des Tiegels (5) so ist, daß ein Molekularstrahl, der aus diesem Tiegel (5) austritt, näherungsweise elliptischen Querschnitt aufweist.

13. Vorrichtung nach Anspruch 11 oder 12, bei der die vorbestimmte Substratfläche (4) als kreisförmig vorgesehen ist, bei der die Effusionszelle (6) so angeordnet ist, daß eine Mittelachse (2) der Effusionszelle (6) außerhalb des Mittelpunktes (7) dieser Substratfläche (4) verläuft, und bei der die Mittelachse (3) des Tiegels (5) zumindest näherungsweise auf den Mittelpunkt (7) dieser Substratfläche (4) ausgerichtet ist.

14. Vorrichtung nach Anspruch 13, bei der die Effusionszelle (6) eine Tiegelhalterung (1) mit einer einen Winkel zwischen der Mittelachse (2) der Effusionszelle (6) und der Mittelachse (3) des Tiegels (5) bewirkenden Formgebung hat.

15. Vorrichtung nach einem der Ansprüche 11 bis 14, bei der ein Kragen an dem Tiegel (5) vorhanden ist, mit dem der Tiegel (5) an der Effusionszelle (6) befestigt ist, und bei der dieser Kragen eine derartige Form hat, daß ein Winkel größer als Null zwischen der Mittelachse (3) des Tiegels (5) und der Mittelachse (2) der Effusionszelle (6) bewirkt ist.

16. Vorrichtung nach einem der Ansprüche 11 bis 15, bei der ein Kragen an dem Tiegel (5) vorhanden ist, mit dem der Tiegel (5) an der Effusionszelle (6) befestigt ist, und bei der dieser Kragen eine derartige Form hat, daß ein Innenraum der Effusionszelle (6), der sich zwischen einer Außenwand des Tiegels (5) und einer Innenwand der Effusionszelle (6) befindet, nach außen abgeschlossen ist.

17. Vorrichtung nach einem der Ansprüche 11 bis 16, bei der die Effusionszelle (6) eine Tiegelhalterung (1) zur Befestigung des Tiegels (5) hat und bei der diese Tiegelhalterung (1) schräg zu der durch den vorderen Rand der Effusionszelle (6) gebildeten Ebene ausgerichtet ist.

18. Vorrichtung für Gebrauch in einer Molekularstrahlepitaxieanlage zum Beschichten eines Substrates, wobei dieses Substrat an einem vorbestimmten Ort angebracht werden kann, wobei diese Vorrichtung umfaßt
eine Effusionszelle (6),
einen Tiegel (5) mit einer Öffnung, mit einem Öffnungswinkel und mit einem in einer zu einer Mittelachse (3) dieses Tiegels senkrechten Ebene durch diesen Öffnungswinkel begrenzten, von der Kreisform abweichenden Querschnitt in dieser Effusionszelle (6) und wobei diese Effusionszelle (6) so angeordnet ist, daß eine Mittelachse (2) dieser Effusionszelle (6) außerhalb dieses Mittelpunktes (7) eines zu beschichtenden Substrates (4) verläuft, und wobei dieser Tiegel (5) relativ zu dieser Effusionszelle (6) verkippt ist, so daß eine Mittelachse (3) dieses Tiegels (5) auf diesen Mittelpunkt (7) eines zu beschichtenden Substrates (4) ausgerichtet ist.

19. Vorrichtung nach Anspruch 18, mit einer Tiegelhalterung (1) der Effusionszelle (6) mit einer einen Winkel größer als Null zwischen der Mittelachse (3) des Tiegels (5) und der Mittelachse (2) der Effusionszelle (6) bewirkenden Formgebung.

20. Vorrichtung nach Anspruch 18 oder 19, bei der der Tiegel (5) einen Kragen zur Befestigung des Tiegels (5) in der Effusionszelle (6) aufweist und bei der dieser Kragen eine Formgebung hat, die einen Winkel größer als Null zwischen der Mittelachse (3) des Tiegels (5) und der Mittelachse (2) der Effusionszelle (6) bewirkt.

21. Vorrichtung nach einem der Ansprüche 18 bis 20, bei der der Tiegel (5) einen Kragen zur Befestigung des Tiegels (5) in der Effusionszelle (6) aufweist und bei der dieser Kragen eine derartige Form hat, daß ein Innenraum der Effusionszelle (6) der sich zwischen einer Außenwand des Tiegels (5) und einer Innenwand der Effusionszelle (6) befindet, nach außen abgeschlossen ist.

22. Vorrichtung nach einem der Ansprüche 18 bis 21, bei der die Effusionszelle (6) eine Tiegelhalterung (1) zur Befestigung des Tiegels (5) hat und bei der diese Tiegelhalterung (1) schräg zu der durch den vorderen Rand der Effusionszelle (6) gebildeten Ebene ausgerichtet ist.

**Claims**

1. Crucible for producing a molecular beam for a molecular beam epitaxy system, having an aperture, having an aperture angle, having a cross-section limited by this aperture angle, and having a centre axis which defines the direction of the molecular beam, characterized in that the crucible (5) has, in a plane perpendicular to the centre axis (3), a cross-section, limited by this aperture angle, which deviates from a circular shape.

2. Crucible according to Claim 1, characterized in that the cross-section of the crucible (5) is essentially elliptical.

3. Arrangement of a crucible according to Claim 1 or 2 relative to an intended centre point (7) on a surface of an object (4) to be coated, characterized in that the centre axis (3) of the crucible (5) is aligned with this centre point (5).

4. Arrangement of a crucible according to one of Claims 1 to 3 relative to an intended centre point (7) on a surface of an object (4) to be coated, characterized in that the centre axis (3) extends obliquely with respect to this surface of the object (4) to be coated.

5. Arrangement of a crucible for producing a molecular beam, in particular a crucible according to one of Claims 1 to 4, in a cell (6) of a molecular beam epitaxy system, in which this crucible (5) has a centre axis (3) determining the direction of the molecular beam and this cell (6) has a centre axis (2), characterized in that the crucible (5) is arranged in such a way that these centre axes (2, 3) extend obliquely with respect to each other.

6. Arrangement according to Claim 5, characterized in that the centre axis (3) of the crucible (5) is aligned with an intended centre point (7) on a surface of an object (4) to be coated.

7. Arrangement according to Claim 5 or 6, characterized in that the centre axis (3) of the crucible (5) extends obliquely with respect to the surface of the object (4) to be coated.

8. Arrangement according to one of Claims 5 to 7, characterized in that the cell (6) has a crucible mount (1) with a shape establishing the angle between the centre axis (2) of the cell (6) and the centre axis (3) of the crucible (5).

9. Arrangement according to one of Claims 5 to 8, characterized in that a collar, provided on the crucible (5) for fastening the crucible (5) in the cell (6), is designed in such a way that an intended alignment of the centre axis (3) of the crucible (5) is thereby established.

10. Arrangement according to one of Claims 5 to 9, characterized in that a collar, provided on the crucible (5) for fastening the crucible (5) in the cell (6), is designed in such a way that the interior space of the cell (6), located between the outer wall of the crucible (5) and the inner wall of the cell (6), is closed off with respect to the outside.

11. Device for use in a molecular beam epitaxy system for coating a substrate, it being possible to fix this substrate at a predetermined position, in such a way that it assumes a predetermined substrate area (4), this device comprising an effusion cell (6), a crucible (5) in this effusion cell (6), this crucible (5) being arranged off-centre relative to this predetermined position, this crucible (5) having an aperture angle (a + a'), a shape, deviating from a circular shape, of the cross-section, extending perpendicularly to a centre axis (3) of the crucible (5) and limited by this aperture angle, and an alignment of this centre axis (3) which together define a cross-section and a direction of a molecular beam emerging from this crucible (5), in such a way that this molecular beam covers this predetermined position and strikes this predetermined substrate area (4) at least substantially exactly.

12. Device according to Claim 11, in which the predetermined substrate area (4) is provided as circularly shaped, and in which the shape of the cross-section of the crucible (5), extending perpendicularly to the centre axis (3), is such that a molecular beam emerging from this crucible (5) has an approximately elliptical cross-section.

13. Device according to Claim 11 or 12, in which the predetermined substrate area (4) is provided as circularly shaped, in which the effusion cell (6) is arranged in such a way that a centre axis (2) of the effusion cell (6) extends outside the centre point (7) of this substrate area (4), and in which the centre axis (3) of the crucible (5) is aligned at least approximately with the centre point (7) of this substrate area (4).

14. Device according to Claim 13, in which the effusion cell (6) has a crucible mount (1) with a shape establishing an angle between the centre axis (2) of the effusion cell (6) and the centre axis (3) of the crucible (5).

15. Device according to one of Claims 11 to 14, in which there is on the crucible (5) a collar, using which the crucible (5) is fastened on the effusion cell (6), and in which this collar has a shape such that an angle of greater than zero is established between the centre axis (3) of the crucible (5) and the centre axis (2) of the effusion cell (6).

16. Device according to one of Claims 11 to 15, in which there is on the crucible (5) a collar, using which the crucible (5) is fastened on the effusion cell (6), and in which this collar has a shape such that an interior space of the effusion cell (6), which is located between an outer wall of the crucible (5) and an inner wall of the effusion cell (6), is closed off with respect to the outside.

17. Device according to one of Claims 11 to 16, in which the effusion cell (6) has a crucible mount (1) for fastening the crucible (5), and in which this crucible mount (1) is aligned obliquely with respect to the plane formed by the front edge of the effusion cell (6).

18. Device for use in a molecular beam epitaxy system for coating a substrate, it being possible to fix this substrate at a predetermined position, this device comprising an effusion cell (6), a crucible (5) in this effusion cell (6), having an aperture, having an aperture angle, and having a cross-section, deviating from a circular shape, limited by this aperture angle in a plane perpendicular to a centre axis (3) of this crucible, and this effusion cell (6) being arranged in such a way that a centre axis (2) of this effusion cell (6) extends outside this centre point (7) of a substrate (4) to be coated, and this crucible (5) being inclined relative to this effusion cell (6) in such a way that a centre axis (3) of this crucible (5) is aligned with this centre point (7) of a substrate (4) to be coated.

19. Device according to Claim 18, having a crucible mount (1) of the effusion cell (6), with a shape establishing an angle of greater than zero between the centre axis (3) of the crucible (5) and the centre axis (2) of the effusion cell (6).

20. Device according to Claim 18 or 19, in which the crucible (5) has a collar for fastening the crucible (5) in the effusion cell (6), and in which this collar has a shape which establishes an angle of greater than zero between the centre axis (3) of the crucible (5) and the centre axis (2) of the effusion cell (6).

21. Device according to one of Claims 18 to 20, in which the crucible (5) has a collar for fastening the crucible (5) in the effusion cell (6), and in which this crucible has a shape such that an interior space of the effusion cell (6), which is located between an outer wall of the crucible (5) and an inner wall of the effusion cell (6), is closed off with respect to the outside.

22. Device according to one of Claims 18 to 21, in which the effusion cell (6) has a crucible mount (1) for fastening the crucible (5), and in which this crucible mount (1) is aligned obliquely with respect to the plane formed by the front edge of the effusion cell (6).

**Revendications**

1. Creuset pour produire un faisceau (rayon) moléculaire pour une installation d'épitaxie à faisceau moléculaire, comportant
une ouverture,
un angle d'ouverture,
une section transversale limitée par cet angle d'ouverture, et
un axe médian définissant la direction du faisceau moléculaire,
caractérisé par le fait
que le creuset (5) possède, dans un plan perpendiculaire à l'axe médian (3), une section transversale limitée par cet angle d'ouverture et qui diffère de la forme circulaire.

2. Creuset suivant la revendication 1, caractérisé par le fait que la section transversale du creuset (5) possède une forme essentiellement elliptique.

3. Disposition d'un creuset suivant la revendication 1 ou 2 par rapport à un centre prévu (7) sur une surface d'un objet à recouvrir (4), caractérisée par le fait que l'axe médian (3) du creuset (5) est dirigé sur ce centre (7).

4. Disposition d'un creuset suivant l'une des revendications 1 à 3 par rapport à un centre prévu (7) sur une surface d'un objet à recouvrir (4), caractérisée par le fait que l'axe médian (3) est oblique par rapport à cette surface de l'objet à recouvrir (4).

5. Disposition d'un creuset pour la production d'un faisceau moléculaire, notamment d'un creuset suivant l'une des revendications 1 à 4, dans une cellule (6) d'une installation d'épitaxie à faisceau moléculaire, dans laquelle ce creuset (5) possède un axe médian (3) déterminant la direction du faisceau moléculaire et cette cellule (6) possède un axe médian (2),
caractérisée par le fait que le creuset (5) est disposé de telle sorte que ces axes médians (2,3) sont obliques l'un par rapport à l'autre.

6. Disposition suivant la revendication 5, caractérisée par le fait que l'axe médian (3) du creuset (5) est dirigé sur un centre prévu (7) sur une surface d'un objet à recouvrir (4).

7. Disposition suivant la revendication 5 ou 6, caractérisée par le fait que l'axe médian (3) du creuset (5) est oblique par rapport à la surface de l'objet à recouvrir (4).

8. Disposition suivant l'une des revendications 5 à 7, caractérisée par le fait que la cellule (6) possède un support de creuset (1) possédant une configuration déterminant l'angle entre l'axe médian (2) de la cellule (6) et l'axe médian (3) du creuset (5).

9. Disposition suivant l'une des revendications 5 à 8, caractérisée en ce qu'un collet prévu sur le creuset (5) pour la fixation de ce dernier dans la cellule (6) est agencé de telle sorte qu'il détermine une orientation prévue de l'axe médian (3) du creuset (5).

10. Disposition suivant l'une des revendications 5 à 9, caractérisée par le fait qu'un collet prévu sur le creuset (5) pour la fixation de ce dernier dans la cellule (6) est agencé de telle sorte que l'espace intérieur de la cellule (6), situé entre la paroi extérieure du creuset (5) et la paroi intérieure de la cellule (6), est fermé en direction de l'extérieur.

11. Dispositif destiné à être utilisé dans une installation d'épitaxie à faisceau moléculaire pour recouvrir un substrat, ce substrat pouvant être disposé en un emplacement prédéterminé de telle sorte qu'il occupe une surface prédéterminée (4) du substrat, ce dispositif comprenant une cellule à effusion (6),
un creuset (5) situé dans cette cellule à effusion (6), ce creuset (5) étant disposé d'une manière excentrée par rapport à cet emplacement prédéterminé,
et dans lequel ce creuset (5) possède un angle d'ouverture (a + a'), et une section transversale, qui diffère de la forme circulaire, est perpendiculaire à l'axe médian (3) du creuset (5) et est limitée par cet angle d'ouverture, et
cet axe médian (3) possède une orientation, ce qui définit conjointement une section transversale et une direction d'un faisceau moléculaire sortant de ce creuset (5), de sorte que ce faisceau moléculaire balaye cet emplacement prédéterminé et rencontre au moins d'une manière suffisamment précise cette surface prédéterminée (4) du substrat.

12. Dispositif suivant la revendication 11,
dans lequel la surface prédéterminée (4) du substrat est prévue avec une forme circulaire, et
dans lequel la forme de la section transversale du creuset (5), qui est perpendiculaire à l'axe médian (3), est telle qu'un faisceau moléculaire, qui sort du creuset (5), possède une section transversale approximativement elliptique.

13. Dispositif suivant la revendication 11 ou 12,
dans lequel la surface prédéterminée (4) du substrat est prévue avec une forme circulaire,
dans lequel la cellule à effusion (6) est disposée de telle sorte qu'un axe médian (2) de la cellule à effusion passe à l'extérieur du centre (7) de cette surface (4) du substrat, et
dans lequel l'axe médian (3) du creuset (5) est dirigé au moins approximativement sur le centre (7) de cette surface (4) du substrat.

14. Dispositif suivant la revendication 13,
dans lequel la cellule à effusion (6) possède un support de creuset (1) comportant une configuration déterminant un angle entre l'axe médian (2) de la cellule à effusion (6) et l'axe médian (3) du creuset (5).

15. Dispositif suivant l'une des revendications 11 à 14,
dans lequel sur le creuset (5) est prévu un collet au moyen duquel le creuset (5) est fixé à la cellule à effusion (6), et dans lequel ce collet possède une forme telle qu'un angle supérieur à zéro est établi entre l'axe médian (3) du creuset (5) et l'axe médian (2) de la cellule à effusion (6).

16. Dispositif suivant l'une des revendications 11 à 15,
dans lequel sur le creuset (5) est prévu un collet à l'aide duquel le creuset (5) est fixé à la cellule à effusion (6), et dans lequel ce collet possède une forme telle qu'un espace intérieur de la cellule à effusion (6) qui est situé entre une paroi extérieure du creuset (5) et une paroi intérieure de la cellule à effusion (6), est fermé en direction de l'extérieur.

17. Dispositif suivant l'une des revendications 11 à 16,
dans lequel la cellule à effusion (6) possède un support de creuset (1) pour la fixation du creuset (5), et
dans lequel ce support de creuset (1) est agencé obliquement par rapport au plan formé par le bord avant de la cellule à effusion (6).

18. Dispositif destiné à être utilisé dans une installation d'épitaxie à faisceau moléculaire pour recouvrir un substrat, ce substrat pouvant être disposé en un emplacement prédéterminé, ce dispositif comprenant
une cellule à effusion (6),
un creuset (5) possédant une ouverture, un angle d'ouverture et une section transversale qui est limitée par cet angle d'ouverture dans un plan perpendiculaire à l'axe médian (3) de ce creuset, et diffère de la forme circulaire, dans cette cellule à effusion (6), et
dans lequel cette cellule à effusion (6) est disposée de telle sorte qu'un axe médian (2) de cette cellule à effusion (6) passe en dehors du centre (7) d'un substrat à recouvrir (4), et ce creuset (5) est basculé par rapport à cette cellule à effusion (6) de sorte qu'un axe central (3) du creuset (5) est dirigé sur ce centre (7) d'un substrat à recouvrir (4).

19. Dispositif suivant la revendication 18,
comportant un support de creuset (1) de la cellule à effusion (6), possédant une configuration qui détermine un angle supérieur à zéro entre l'axe médian (3) du creuset (5) et l'axe médian (2) de la cellule à effusion (6).

20. Dispositif suivant la revendication 18 ou 19,
dans lequel le creuset (5) possède un collet pour la fixation du creuset (5) dans la cellule à effusion (6), et
dans lequel ce collet possède une configuration qui détermine un angle supérieur à zéro entre l'axe médian (3) du creuset (5) et l'axe médian (2) de la cellule à effusion (6).

21. Dispositif suivant l'une des revendications 18 à 20,
dans lequel le creuset (5) possède un collet pour la fixation du creuset (5) dans la cellule à effusion (6),
et dans lequel ce collet possède une forme telle qu'un espace intérieur de la cellule à effusion (6), qui est situé entre la paroi extérieure du creuset (5) et une paroi intérieure de la cellule à effusion (6), est fermé en direction de l'extérieur.

22. Dispositif suivant l'une des revendications 18 à 21,
dans lequel la cellule à effusion (6) possède un support de creuset (1) pour la fixation du creuset (5), et
dans lequel ce support de creuset (1) est orienté obliquement par rapport au plan formé par le bord avant de la cellule à effusion (6).

# FIG 1

# FIG 2